# EUROPEAN PATENT SPECIFICATION

(11) **EP 3 734 665 B1**
(45) Date of publication and mention of the grant of the patent: **02.04.2025**
(21) Application number: 20169735.6
(22) Date of filing: 16.04.2020
(51) Int. Cl.: H01L 25/075, H01L 33/62, H01L 33/64, H01L 25/16, H10K 59/124, H10K 59/131

(54) **ELECTRONIC DEVICE**
ELEKTRONISCHE VORRICHTUNG
DISPOSITIF ÉLECTRONIQUE

(30) Priority: 29.04.2019 US 201962839794 P; 31.12.2019 CN 201911410192
(43) Date of publication of application: 04.11.2020
(73) Proprietor: InnoLux Corporation, Jhu-Nan, Miao-Li County 350 (TW)
(72) Inventor: Kao, Chi-Lun, 350 Miao-Li County (TW); Tseng, Ming-Chun, 350 Miao-Li County (TW); Kao, Ker-Yih, 350 Miao-Li County (TW); Tsai, Wen-Chang, 350 Miao-Li County (TW); Sung, Chao-Chin, 350 Miao-Li County (TW)
(74) Representative: Straus, Alexander

(56) References cited:
- US-A1- 2008 143 255
- US-A1- 2009 000 812
- US-A1- 2013 001 563
- US-A1- 2013 056 714
- US-A1- 2014 367 720
- US-A1- 2017 345 801

## Description

### Field of the Disclosure

The present disclosure relates to an electronic device, more particularly to an electronic device having an organic layer including a through hole portion overlapped with a bonding pad that can improve reliability or yields.

### Background of the Disclosure

US 2013/0056714 A1 describes an organic EL display including: a plurality of first electrodes provided in a display region on a drive substrate, the plurality of first electrodes each including a laminated film having two or more layers; an organic layer provided on the plurality of first electrodes and including a light emitting layer; an electrode pad provided in a peripheral region around the display region; and a second electrode provided on the organic layer as well as the electrode pad, wherein the laminated film includes a first conductive film functioning as a reflective film, and a second conductive film provided below the first conductive film, and having a reflectance lower than that of the first conductive film, and the electrode pad corresponds to a part of the laminated film, and includes a conductive film made of a material same as that of the second conductive film.

US 2017/0345801 A1 describes a display apparatus and a fabricating method thereof. The display apparatus includes a substrate, a light emitting diode, a first bump, a first insulating layer and a second insulating layer. The light emitting diode has a first surface and a second surface opposite each other, wherein the first surface faces the substrate. The light emitting diode is bonded to the substrate through the first bump. The first insulating layer is disposed on a periphery of the first bump and the light emitting diode, and contacts the first bump and the first surface. The second insulating layer is disposed on the substrate and surrounds at least a portion of the first insulating layer.

Electronic devices are generally used in daily life. With the development of electronic devices, the requirements for the quality and functions of electronic devices are increased. Electronic devices still do not meet user's requirements in various aspects for now. For example, there are still some reliability or yields problems of electronic devices. Therefore, how to continuously improve the reliability or yields of electronic devices has become an issue.

### Summary of the Disclosure

This in mind, the present disclosure aims at providing an electronic device having improved reliability or yields. In the electronic device of this disclosure, the conductive layer (such as a top surface of the conductive layer) under the bonding pad and connected to the bonding pad may include a plurality of recesses or through holes. When the temperature rises, the recesses or through holes can provide extra space for the expansion of the conductive layer, thereby reducing peeling or warping between layers under the bonding pad.

This is achieved by an electronic device according to the independent claims. The dependent claims pertain to corresponding further developments and improvements.

As will be seen more clearly from the detailed description following below, an electronic device is provided by the present disclosure. The electronic device includes a substrate, a dielectric layer, a driving layer, an organic layer and a light emitting unit. The driving layer is disposed on the substrate. The driving layer includes a thin film transistor, and the thin film transistor includes a drain, a source and a gate. The organic layer is disposed on the driving layer. The organic layer includes a connecting hole and a through hole portion, and the through hole portion includes a through hole. The light emitting unit is disposed on the organic layer. The dielectric layer is disposed between the gate and the organic layer. The light emitting unit is disposed on the organic layer and electrically connected to the driving layer by a bonding pad. A ratio of an area of the through hole portion overlapped with the bonding pad to an area of the bonding pad is greater than or equal to 0.3 and less than or equal to 3 in a top view direction of the electronic device. The light emitting unit includes a conductive pad electrically connected to the bonding pad, the light emitting unit overlaps the bonding pad, and the conductive pad overlaps the bonding pad in the top view direction. A portion of the drain is exposed by the connecting hole. A portion of an upper surface of the dielectric layer is exposed by the through hole, wherein the upper surface of the dielectric layer is disposed far away from the substrate in the top view direction.

### Brief Description of the Drawings

In the following, the disclosure is further illustrated by way of example, taking reference to the accompanying drawings. Thereof
FIG 1 is a schematic diagram illustrating an electronic device according to a first embodiment of the present disclosure,
FIG 2 is a cross-sectional schematic diagram illustrating a structure taken along the line A-A' of FIG 1,
FIG 3 is a schematic diagram in a top view direction illustrating a bonding pad and a through hole portion under the bonding pad according to the first embodiment of the present disclosure,
FIG 4 is a schematic diagram illustrating a through hole portion under a bonding pad according to a second embodiment of the present disclosure,
FIG 5 is a schematic diagram illustrating a through hole portion under a bonding pad according to a third embodiment of the present disclosure,
FIG 6 is a schematic diagram illustrating a through hole portion and a signal line under a bonding pad according to a fourth embodiment of the present disclosure,
FIG 7 is a cross-sectional schematic diagram illustrating an electronic device according to a fifth embodiment of the present disclosure,
FIG 8 is a schematic diagram illustrating a through hole portion and a signal line under a bonding pad according to the fifth embodiment of the present disclosure.

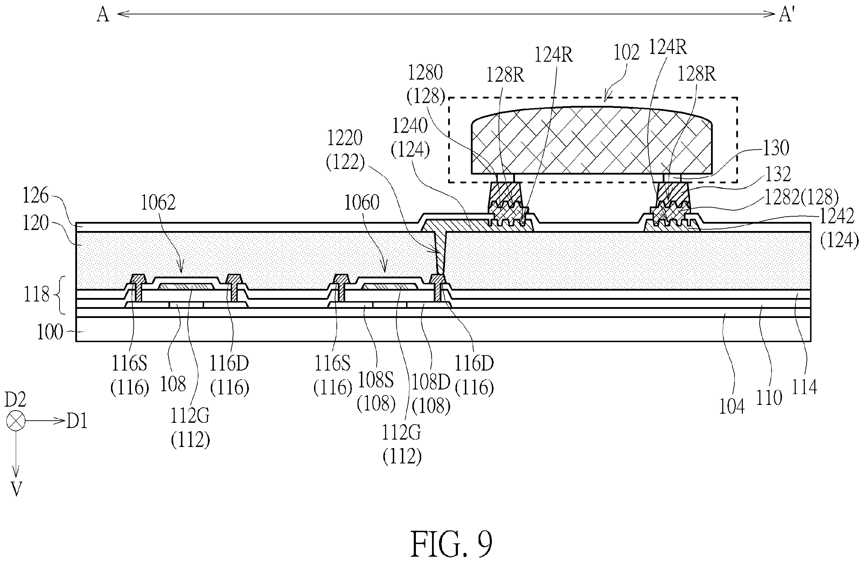

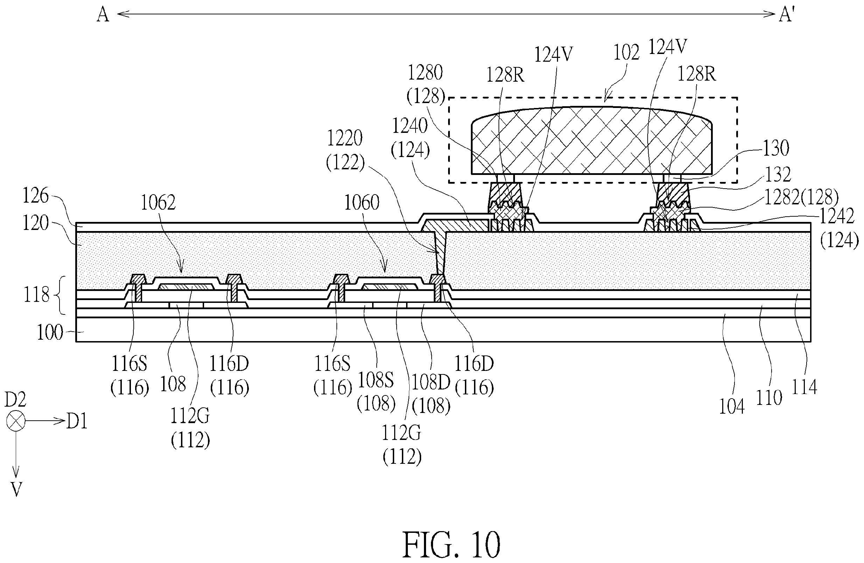

It is noted that fig. 9 and 10 show a cross-sectional schematic diagram illustrating an electronic device not forming part of the claimed invention.

### Detailed Description

The present disclosure may be understood by reference to the following detailed description, taken in conjunction with the drawings as described below. It is noted that, for purposes of illustrative clarity and being easily understood by the readers, various drawings of this disclosure show a portion of the electronic device, and certain elements in various drawings may not be drawn to scale. In addition, the number and dimension of each element shown in drawings are for illustrative and are not intended to limit the scope of the present disclosure.

Certain terms are used throughout the description and following claims to refer to particular elements. As one skilled in the art will understand, electronic equipment manufacturers may refer to an element by different names. This document does not intend to distinguish between elements that differ in name but not function. In the following description and in the claims, the terms "include", "comprise" and "have" are used in an open-ended fashion, and thus should be interpreted to mean "include, but not limited to...".

It will be understood that when an element or layer is referred to as being "on" another element or layer, it may be directly on the other element or layer, or intervening elements or layers may be presented. In contrast, when an element is referred to as being "directly on" another element or layer, there are no intervening elements or layers presented. On the other hand, when an element or layer is referred to as being "on" another element or layer, the two elements or layers are in an up-down relationship in a top view direction. The element or layer can be located "on" or "below" the other element or layer, and the up-down relationship depends on orientation of the electronic device.

It will be understood that when an element or layer is referred to as being "connected to" another element or layer, it may be directly connected to the other element or layer, or intervening elements or layers may be presented. In contrast, when an element is referred to as being "directly connected to" another element or layer, there are no intervening elements or layers presented. On the other hand, when an element is referred to as being "coupled to" another element, the element can be directly connected to the another element, or the element can be indirectly connected (such as electrically connected) to the another element by one or a plurality of elements.

The term "about", "substantially", "equal", or "same" generally refers to falling within 20% of a given value or range, or to falling within 10%, 5%, 3%, 2%, 1%, or 0.5% of a given value or range.

Although terms such as first, second, third, etc., may be used to describe diverse constituent elements, such constituent elements are not limited by the terms. The terms are used only to discriminate a constituent element from other constituent elements in the specification. The claims may not use the same terms, but instead may use the terms first, second, third, etc. with respect to the order in which an element is claimed. Accordingly, in the following description, a first constituent element may be a second constituent element in a claim.

It should be noted that the technical features in different embodiments described in the following can be replaced, recombined, or mixed with one another to constitute another embodiment. The scope of protection is defined by the appended set of claims.

An electronic device of the present disclosure may include a display device, an antenna device, a sensing device, a lighting device, a tiled device, other appropriate device, or the combinations of the above-mentioned devices, but not limited thereto. The electronic device may be a bendable or flexible electronic device. In an embodiment, the electronic device may include a display medium and/or a light emitting unit. For example, the electronic device can include a liquid crystal layer or a light emitting diode (LED). The light emitting diode may be organic light emitting diode (OLED) or inorganic light emitting diode, for example, mini LED, micro LED, quantum dot, quantum dot LED (QLED or QDLED), fluorescence, phosphor, other suitable materials, or the combinations of the above-mentioned materials may be used, but not limited thereto. Hereinafter, it is illustrative of an example that the electronic device is the display device, but not limited thereto.

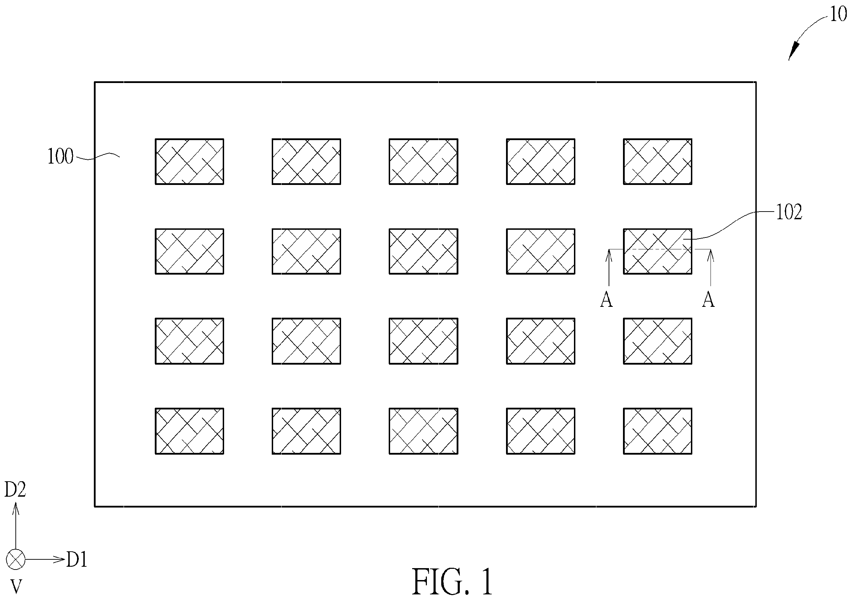

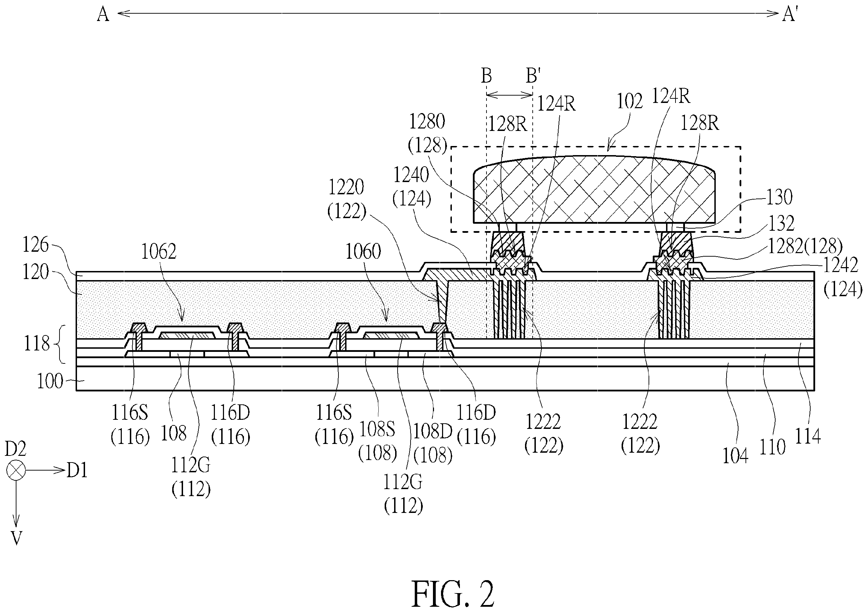

Please refer to FIG. 1 and FIG 2, FIG 1 is a schematic diagram illustrating an electronic device according to a first embodiment of the present disclosure, and FIG 2 is a cross-sectional schematic diagram illustrating a structure taken along the line A-A' of FIG 1. An electronic device 10 includes a substrate 100, a driving layer 118, an organic layer 120 (also known as a planarization layer) and a light emitting unit 102. In some embodiments, the driving layer 118 is disposed on the substrate 100, and the organic layer 120 is disposed on the driving layer 118 and includes a through hole portion 122. The light emitting unit 102 is disposed on the organic layer 120, and the light emitting unit 102 is electrically connected to the driving layer 118 by a bonding pad (such as a bonding pad 1280 or a bonding pad 1282). The light emitting unit 102 can be arranged in a matrix or other ways (e.g. pentile arrangement), but not limited thereto. In some embodiments, the light emitting unit 102 may include a light emitting diode (not shown in the figure). A light converting material (not shown in the figure) may be disposed on the light emitting diode, and the light converting material may for example include quantum dot (QD) material, fluorescence material, color filter (CF) material, phosphor material, other suitable light converting materials, or the combinations of the above-mentioned materials, but not limited thereto. In some embodiments (not shown in the figure), the light converting material may for example cover the light emitting diode. In some embodiments, a plurality of layers (such as a conductive layer and/or an insulating layer) may be disposed between the light emitting unit 102 and the substrate 100, but not limited thereto.

In addition, thin film transistors, integrated circuits, circuits, conductive pads, conductive lines or other electronic components may be disposed on the substrate 100. The substrate 100 may include rigid substrate, flexible substrate or the combinations of the above-mentioned substrates, but not limited thereto. In some embodiments, the substrate 100 may include foldable substrate or deformable substrate, but not limited thereto. In some embodiments, the material of the substrate 100 may include glass, quartz, organic polymer, plastic, metal, ceramic, other suitable materials, or the combinations of the above-mentioned materials, but not limited thereto. If the material of the substrate 100 includes organic polymer, the organic polymer may for example include polyimide (PI), polyethylene terephthalate (PET), polycarbonate (PC), or the combinations of the above-mentioned materials, but not limited thereto.

Please refer to FIG 2. The driving layer 118 may include a buffer layer 104 disposed adjacent to the substrate 100. The driving layer 118 includes a thin film transistor. The material of the buffer layer 104 may include silicon oxide, silicon nitride, other suitable materials or the combinations of the above-mentioned materials, but not limited thereto. The thin film transistor 1060 (or the thin film transistor 1062) includes a semiconductor layer 108 (e.g. including a drain region 108D and a source region 108S). The material of the semiconductor layer 108 may include polycrystalline silicon, amorphous silicon (e.g. low-temperature poly-silicon) or metal oxide semiconductor (e.g. indium gallium zinc oxide), but not limited thereto. The material of the semiconductor layer 108 of the thin film transistor 1060 and the material of the semiconductor layer 108 of the thin film transistor 1062 can be the same, and also can be different.

In addition, a gate insulating layer 110 is disposed on the semiconductor layer 108, and a conductive layer 112 is disposed on the gate insulating layer 110, but not limited thereto. As shown in FIG 2, the conductive layer 112 can be used to form a gate 112G of the thin film transistor 1060 (or the thin film transistor 1062). In other words, the gate 112G can be a portion of the conductive layer 112. In addition, a dielectric layer 114 and a conductive layer 116 are disposed on the conductive layer 112 sequentially. These layers can be adjusted according to different requests. The conductive layer 116 can be used to form a data line, a source 116S and/or a drain 116D of the thin film transistor 1060(or the thin film transistor 1062). In other words, the source 116S and/or the drain 116D may be a portion/portions of the conductive layer 116, but not limited thereto. In some embodiments, the material of the conductive layer 112 and the conductive layer 116 may include metallic materials, transparent conductive materials, or combinations thereof, but not limited thereto.

In the present embodiment, the thin film transistors in FIG 2 are top gate thin film transistors for example, but not limited thereto. In other embodiments, the thin film transistors may include bottom gate thin film transistors, dual gate thin film transistors (also referred to as double gate thin film transistors), but not limited thereto.

Please refer to FIG 2, the electronic device 10 may further include a conductive layer 124 and an insulating layer 126 disposed on the organic layer 120. It is noticed that in the present embodiment, the driving layer 118 may be defined by layers between the substrate 100 and the conductive layer 116 (such as the source 116S and the drain 116D). The driving layer 118 may include the conductive layer 116 but may not include the substrate 100. In the claimed invention, the organic layer 120 includes at least one connecting hole 1220 and at least one through hole portion 122, and the through hole portion 122 includes at least one through hole. In other words, in a top view direction V of the electronic device (such as a normal direction of the substrate 100), all the through holes 1222 overlapped with the bonding pad 1280 (or the bonding pad 1282) are referred to as the through hole portion 122. In addition, in the top view direction V of the electronic device, the connecting hole 1220 is overlapped with the thin film transistor 1060 (such as being overlapped with the drain 116D), and a portion of the drain 116D is exposed by the connecting hole 1220, such that the conductive layer 124 can be electrically connected to the thin film transistor 1060 through the connecting hole 1220. In the claimed invention, a portion of a surface of the dielectric layer 114 is exposed by the through hole 1222.

In some embodiments, the conductive layer 124 may have a conductive portion 1240 and a conductive portion 1242. The conductive portion 1240 and the conductive portion 1242 can be separated from each other. In other words, the conductive portion 1240 and the conductive portion 1242 may not be directly connected, but not limited thereto. In some embodiments, the conductive portion 1240 and/or the conductive portion 1242 may be correspondingly disposed on the through hole portion 122, and at least a portion of the conductive portion 1240 and/or the conductive portion 1242 may be disposed in the through hole 1222.

In some embodiments, a portion of the conductive portion 1240 may be extended to a position on the connecting hole 1220 and extended into the connecting hole 1220, such that the conductive layer 124 may be electrically connected to the thin film transistor 1060(such as the drain 116D) through the connecting hole 1220. In some embodiments, the portion of the drain 116D exposed by the connecting hole 1220 may contact the conductive portion 1240. In other words, the conductive layer 124 may contact the driving layer 118, but not limited thereto. In some embodiments, the portion of the surface of the dielectric layer 114 exposed by the through hole 1222 may contact the conductive portion 1240 and/or the conductive portion 1242 of the conductive layer 124, but not limited thereto.

Please refer to FIG 2, in some embodiments, the insulating layer 126 may include a plurality of openings that can be used to expose portions of a surface of the conductive layer 124. In addition, the electronic device 10 may further include a conductive layer 128 disposed on the conductive layer 124. The conductive layer 128 includes the bonding pad 1280 and the bonding pad 1282 disposed between the light emitting unit 102 and the conductive layer 124. The bonding pad 1280 and the bonding pad 1282 are respectively disposed on two openings of the insulating layer 126, and a portion of the bonding pad 1280 and/or a portion of the bonding pad 1282 can be filled or disposed in the corresponding opening of the insulating layer 126. The bonding pad 1280 and/or the bonding pad 1282 may be electrically connected to the conductive layer 124 through the openings of the insulating layer 126. For example, the bonding pad 1280 and/or the bonding pad 1282 may contact portions of the surface of the conductive layer 124 through the openings of the insulating layer 126, but not limited thereto. In some embodiments, in the top view direction V of the electronic device 10, the bonding pad 1280 and the bonding pad 1282 are overlapped with the through hole portion 122. In some embodiments, a portion of the conductive portion 1240 may be disposed in the through hole portion 122 (such as the through holes 1222) overlapped with the bonding pad 1280, and a portion of the conductive portion 1242 may be disposed in the through hole portion 122 (such as the through holes 1222) overlapped with the bonding pad 1282.

In some embodiments, the material of the conductive layer 124 may include molybdenum (Mo), copper (Cu), the combination of the above-mentioned materials, or other suitable metals or conductive materials, but not limited thereto. In some embodiments, the material of the conductive layer 128 may include nickel (Ni), gold (Au), the combination of the above-mentioned materials, or other suitable metals or conductive materials, but not limited thereto.

As shown in FIG 2 the conductive layer 128 (the bonding pad 1280 and/or the bonding pad 1282) may be form by deposition process (such as physical vapor deposition or chemical vapor deposition), but not limited thereto. As shown in FIG 2, a plurality of recesses 124R (also referred to as first recesses) may be form on a portion of the top surface of the conductive layer 124 located above the through holes 1222. In other words, the conductive layer 124 may include the plurality of recesses 124R. In some embodiments, a portion of the bonding pad 1280 and/or a portion of the bonding pad 1282 may be disposed in the plurality of recesses 124R. In some embodiments, a plurality of recesses 128R (also referred to as second recesses) may be formed on the top surface of the bonding pad 1280 and/or the bonding pad 1282 located above the recesses 124R. In some embodiments, at least a portion of the plurality of second recesses 128R are overlapped with at least a portion of the plurality of first recesses 124R, but not limited thereto.

It is noticed that the plurality of recesses may not be formed on the top surface of a conductive layer (referring to the conductive layer 124) in the conventional electronic device. Therefore, the conductive layer 124 of the conventional electronic device may be expanded due to heat when the temperature is high, such that the conductive layer 124 and some adjacent layers may be warped because there is no enough space for the conductive layer 124 to expand. Some layers under the bonding pad 1280 and/or the bonding pad 1282 may further be peeling. For example, the organic layer 120 may be peeling from the insulating layer 126 (or inorganic material layer) under the bonding pad, but not limited thereto. Alternatively, the conductive layer 124 and the organic layer 120 under the bonding pad may be peeling from each other. In addition, the substrate under the bonding pad may crack under the influence of thermal expansion and contraction of the conductive layer 124. However, in one of the embodiments of the present disclosure (as shown in FIG 2), the plurality of through holes 1222 are disposed in the organic layer 120, the plurality of recesses 124R may be formed on the top surface of the conductive layer 124 above the through holes 1222. When the temperature is high, the space formed by the recesses 124R (such as the notches formed by the recess 124R) may provide space for heat expansion of the conductive layer 124. The peeling and warping between different layers can be reduced. Similarly, the plurality of recesses 128R of the top surfaces of the bonding pad 1280 and the bonding pad 1282 also have the above-mentioned function.

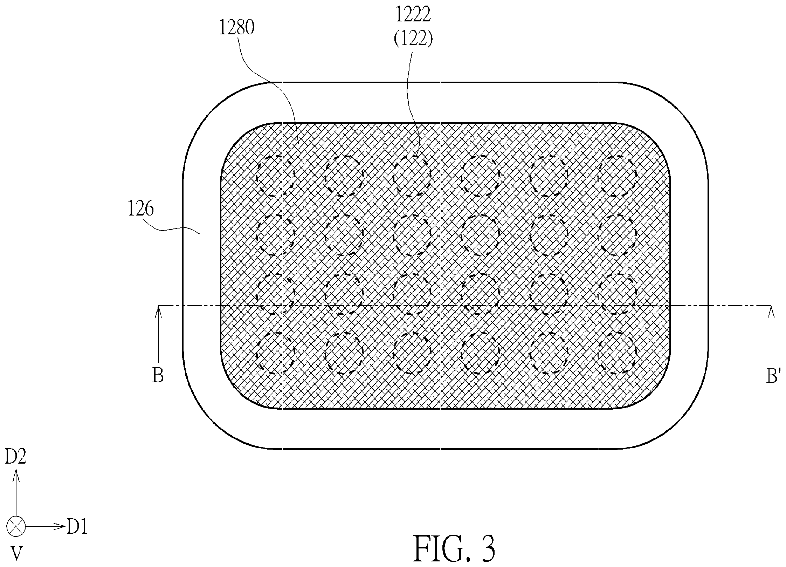

Please refer to FIG 2 and FIG 3, FIG 3 is a schematic diagram in the top view direction illustrating the bonding pad and the through hole portion under the bonding pad according to the first embodiment of the present disclosure. The structure in the B-B' area in FIG 3 corresponds to the B-B' line in FIG 2. Other components and layers are omitted to emphasize the relationship between the bonding pad and the through hole portion. Taking the bonding pad 1280 for example in FIG 3, a plurality of through holes 1222 are disposed under the bonding pad 1280. In the top view direction V of the electronic device, the bonding pad 1280 is overlapped with at least a portion of the through holes 1222. In other embodiments, the through holes 1222 of the organic layer 120 may have different arrangement for different requirements. In addition, in the top view direction V of the electronic device 10, an area of the bonding pad (such as the bonding pad 1280 or the bonding pad 1282) is A, an area of the through hole portion 122 overlapped with the bonding pad (such as a total area of the plurality of the through holes 1222) is B. A ratio (B/A) of the area of the through hole portion 122 overlapped with the bonding pad (B) to the area of the bonding pad (A) is greater than and equal to 0.3 and less than and equal to 3. In some embodiments, the ratio (B/A) may be greater than and equal to 0.5 and less than and equal to 2.5, but not limited thereto. In some embodiments, the ratio (B/A) may be greater than and equal to 0.5 and less than and equal to 2, but not limited thereto. In some embodiments, the ratio (B/A) may be greater than and equal to 0.7 and less than and equal to 1.5, but not limited thereto. It is noticed that the area of the through hole 1222 may be measured by the bottom area of the through hole 1222 (such as a surface adjacent to the substrate 100). In addition, in the top view direction V, the shape of the through hole 1222 may be circular, rectangular, polygonal, a shape with curved edges, irregular shape, or the combinations of the above-mentioned shapes, but not limited thereto.

Please refer to FIG 2, a conductive pad 130 of the light emitting unit 102 is electrically connected to the bonding pad 1280 or the bonding pad 1282 through a solder 132. The solder may be disposed between the bonding pad 1280 (or the bonding pad 1282) and the light emitting unit 102. The light emitting unit 102 includes two conductive pads 130 (such as two pins of the light emitting unit 102). The solder 132 may be disposed between the bonding pad 1280(or the bonding pad 1282) and the conductive pad 130. The light emitting unit 102 may be connected or electrically connected to the bonding pad 1280 (and/or the bonding pad 1282) through the solder 132. In some embodiments, the material of the conductive layer 128 may have good adhesion with the material of the solder 132 or the conductive layer 124. In some embodiments, the bonding pad 1280 and/or the bonding pad 1282 may be disposed between the light emitting unit 102 (such as the conductive pads 130) and the conductive layer 124. The light emitting unit 102 may be electrically connected to the driving layer 118 through the bonding pad 1280 (or the bonding pad 1282) and the conductive layer 124, but not limited thereto. In some embodiments, the material of the conductive pad 130 and the solder 132 may include metal or other suitable conductive materials, but not limited thereto.

Hereinafter, other embodiments of the present disclosure will be described in detail. For simplification, the same components are labeled with the same reference numbers. In order to emphasize the difference between the different embodiments, the difference between the different embodiments will be describe in detail below, and the same technical features will not be repeated.

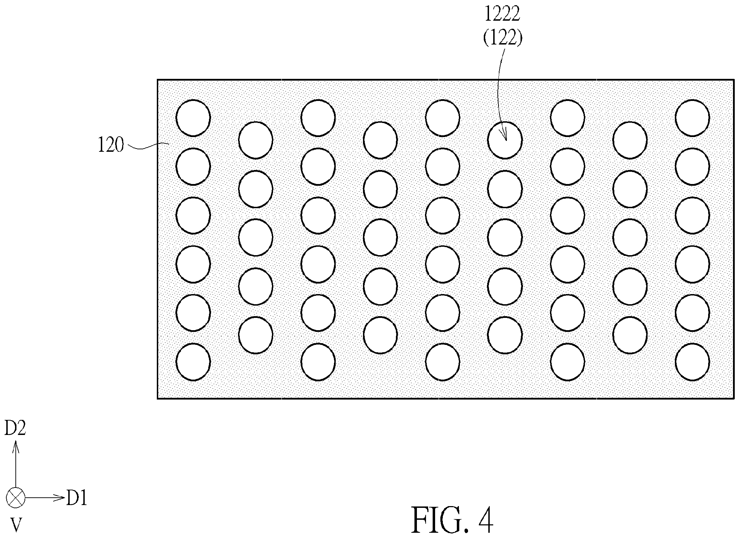

Please refer to FIG 4, FIG 4 is a schematic diagram illustrating a through hole portion under a bonding pad according to a second embodiment of the present disclosure. The difference between the second embodiment and the first embodiment (FIG 3) is that the through holes 1222 in different rows or columns may be disposed misaligned, but not limited thereto. It is noticed that, the shape and the dimension of the through hole 1222 and the gap between the through holes 1222 may be changed or adjusted according to different requirements, and different through holes 1222 may be adjusted irregularly.

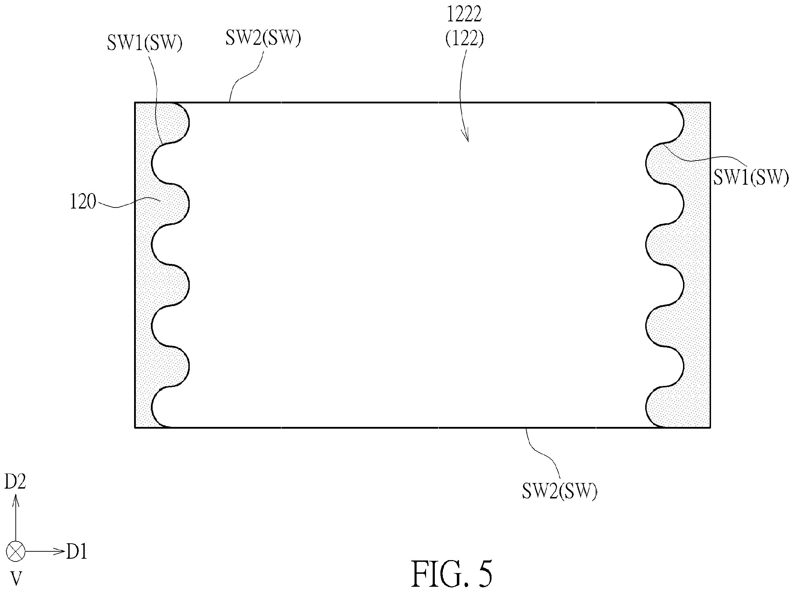

Please refer to FIG 5, FIG 5 is a schematic diagram illustrating a through hole portion under a bonding pad according to a third embodiment of the present disclosure. The difference between the third embodiment and the first embodiment (FIG. 3) is that the through hole portion 122 under the bonding pad 1280 (and/or the bonding pad 1282) may include a through hole 1222 in the present embodiment. In the top view direction V, the shape of the through hole 1222 is different from the shape of the through hole 1222 in FIG 3. In the present embodiment, the area of the through hole 1222 may be greater than the area of the through hole 1222 in the first embodiment, but not limited thereto. As shown in FIG 5, in the top view direction V, the organic layer 120 includes a sidewall SW. For example, the sidewall SW surrounds the through hole 1222. In addition, the sidewall SW may include a plurality of sub-sidewall. Taking FIG 5 as an example, the sidewall SW may include two sub-sidewalls SW1 and two sub-sidewalls SW2, and the sub-sidewall SW1 and the sub-sidewall SW2 are connected to each other to form the sidewall SW. In some embodiments, the shape of the sub-sidewall SW1 may be wave-shaped, and the shape of the sub-sidewall SW2 may be straight, but not limited thereto. In some embodiments, the sub-sidewall SW1 and/or the sub-sidewall SW2 may have different shapes (such as curve, straight line, zigzag, or irregular shape) for different requirements, and the sub-sidewall SW1 and/or the sub-sidewall SW2 may have the same shape or have different shapes.

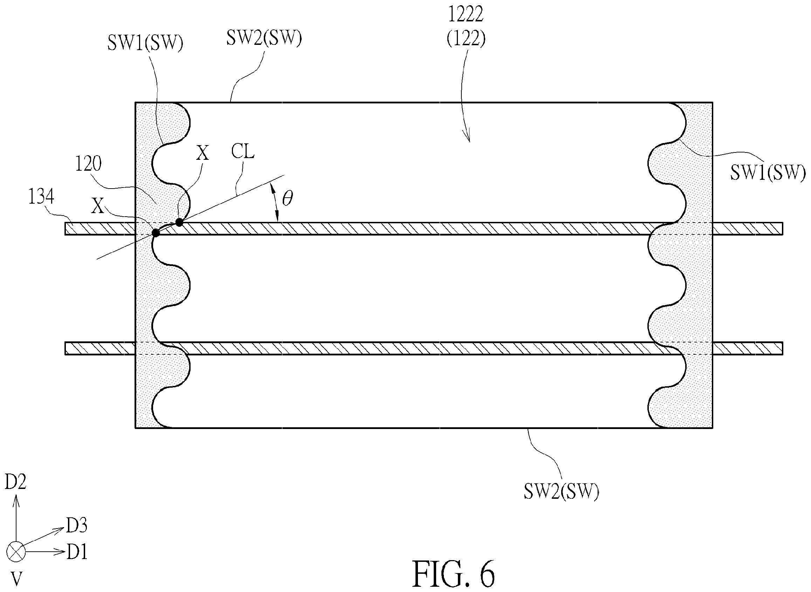

Please refer to FIG 6, FIG 6 is a schematic diagram illustrating a through hole portion and a signal line under a bonding pad according to a fourth embodiment of the present disclosure. For convenience of illustration, only the through hole 1222 of the through hole portion 122 of the organic layer 120 and a signal line 134 are shown in FIG 6, and other components and layers are omitted in FIG 6. The difference between the fourth embodiment and the third embodiment is the driving layer 118 in the present embodiment (referring to FIG. 1) may further include at least one signal line 134. In the top view direction V of the electronic device 10, the signal line 134 may be overlapped with the through hole portion 122 (such as the through hole 1222). In some embodiments, the signal line 134 may be formed by the conductive layer 112, and the signal line 134 may be a scan line, but not limited thereto. In some embodiments, the signal line 134 may be formed by the conductive layer 116, and the signal line 134 may be a data line, but not limited thereto. In some embodiments, the signal line 134 may be formed by other conductive layers, and the signal line 134 may be a power line or other signal lines. In some embodiments, at least one insulating layer (such as a dielectric layer) may be disposed between the signal line 134 and the through hole 1222 to reduce the electrical connection between the signal line 134 and the conductive layer 124 disposed in the through hole 1222.

As shown in FIG 6, the signal line 134 may be extended along a direction (such as a direction D1), but not limited thereto. In addition, the sub-sidewall SW1 may be substantially extended along another direction (such as a direction D2 different from the direction D1), and the sub-sidewall SW2 may be extended along the direction (such as the direction D1), but not limited thereto. The direction D1 is different from the direction D2. For example, the direction D1 and the direction D2 are perpendicular, but not limited thereto. In some embodiments, the extension direction of the sub-sidewall SW2 and the extension direction of the signal line 134 may not be parallel. In some embodiments, the extension direction of the sub-sidewall SW1 and the extension direction of the signal line 134 may not be perpendicular. In some embodiments, two side edges of the signal line 134 may intersect the sub-sidewall SW1 of the organic layer 120 at two intersection points X. An extension line CL is substantially drawn by connecting the two intersection points X, and the extension line CL may be extended along a direction D3. The direction D3 may have an angle θ with the extension direction of the signal line 134 (such as the direction D1. In some embodiments, the angle (such as the angle θ) between the sidewall SW (such as the sub-sidewall SW1) and the signal line 134 may not be a right angle, but not limited thereto. For example, the angle θ may be greater than or equal to 10 degree and less than or equal to 80 degree, but not limited thereto. Since a portion of the conductive layer 124 is disposed in the through holes 1222 of the organic layer 120, a stress (created by the expansion and contraction from the conductive layer 124) applying to the signal line 134 under the conductive layer 124 can be reduced to prevent the signal line 134 from being break when the angle θ between the sidewall SW (such as the sub-sidewall SW1 of the organic layer 120) and the signal line 134 is not a right angle, but not limited thereto.

It is noticed that the through hole 1222 and the signal line 134 in FIG 6 are simplified for illustration, the through hole 1222 may be overlapped with more or less signal lines 134, and the dimensions of the through hole 1222 and the signal line 134 may be adjusted according to different requirements. In other embodiments, the signal line 134 may be formed wider, and the angle (such as the angle θ) between the sidewall SW (such as the sub-sidewall SW1) and the signal line 134 may selectively be a right angle or not to be a right angle.

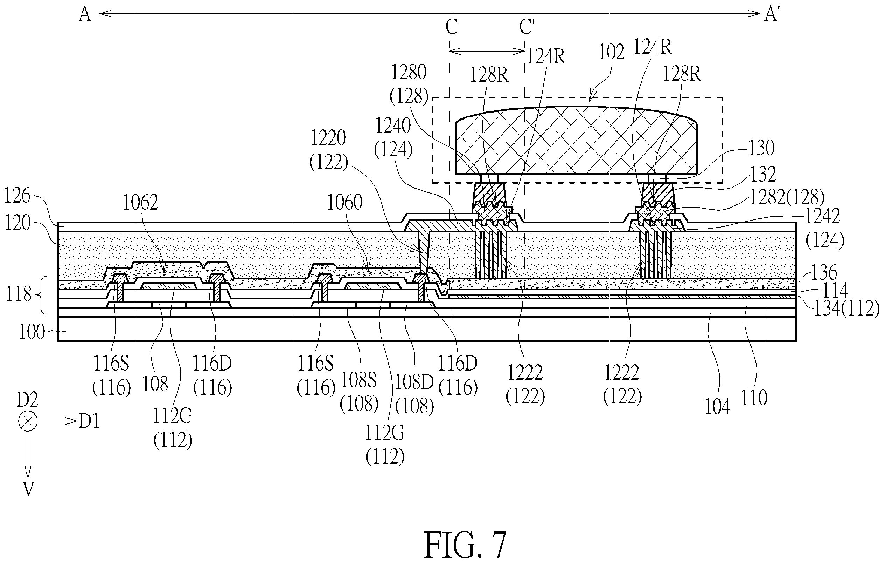

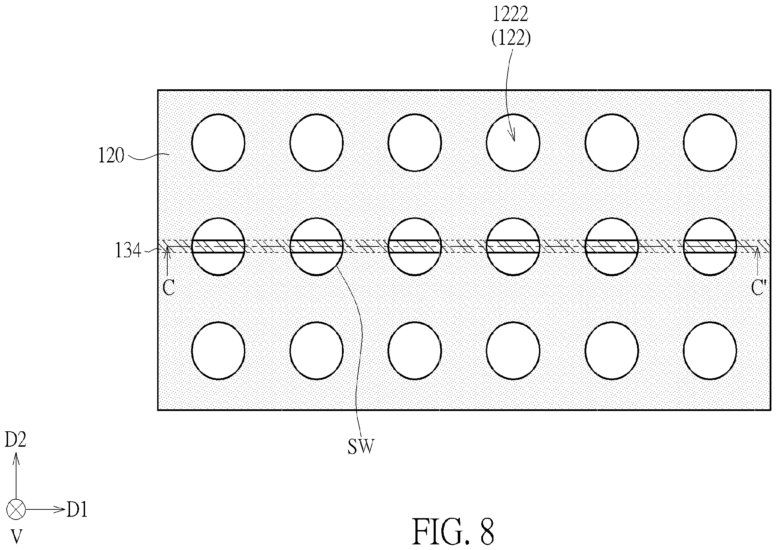

Please refer to FIG 7 and FIG 8, FIG 7 is a cross-sectional schematic diagram illustrating an electronic device according to a fifth embodiment of the present disclosure, FIG. 8 is a schematic diagram illustrating a through hole portion and a signal line under a bonding pad according to the fifth embodiment of the present disclosure, and the structure in the C-C' area in FIG 7 corresponds to the C-C' line in FIG 8. The difference between the fifth embodiment and the first embodiment is that the driving layer 118 in the present embodiment may include at least one signal line 134 (as shown in FIG 7), and the signal line 134 may be overlapped with the through hole portion 122 (such as a plurality of the through holes 1222) (as shown in FIG. 7 and FIG 8) in the top view direction V of the electronic device 10. In FIG 7, the signal line 134 (such as a scan line) may be formed by the conductive layer 112, the signal line 134 may be disposed between the gate insulating layer 110 and the dielectric layer 114, but not limited thereto.

Please refer to FIG 7, the electronic device 10 further includes a dielectric layer 136 disposed between the dielectric layer 114 and the organic layer 120, but not limited thereto. The material of the dielectric layer 136 may include organic insulating materials, inorganic insulating materials, or other suitable insulating materials, but not limited thereto. The connecting hole 1220 of the through hole portion 122 may penetrate the organic layer 120 and the dielectric layer 136 to expose a portion of the surface of the drain 116D, such that the conductive portion 1240 of the conductive layer 124 can be electrically connected to the drain 116D through the connecting hole 1220, but not limited thereto. In some embodiments, the through hole 1222 penetrates the organic layer 120, and the through hole 1222 does not penetrate the dielectric layer 136. In some embodiments (not shown in the figure), the signal line 134 (such as a data line) may be formed by the conductive layer 116, and the signal line 134 may be disposed between the dielectric layer 114 and the dielectric layer 136, but not limited thereto.

According to above arrangements, in the electronic device of the disclosure, the conductive layer (such as a top surface of the conductive layer) under the bonding pad and connected to the bonding pad may include a plurality of recesses or through holes. When the temperature rises, the recesses or through holes can provide extra space for the expansion of the conductive layer, thereby reducing peeling or warping between layers under the bonding pad.

## Claims

1. An electronic device (10), comprising
a substrate (100);
a driving layer (118) disposed on the substrate (100), wherein the driving layer (118) comprises a thin film transistor (1060), and the thin film transistor (1060) comprises a drain (116D), a source (116S) and a gate (112G);
an organic layer (120) disposed on the driving layer (118), the organic layer (120) comprising a connecting hole (1220) and a through hole portion (122), wherein the through hole portion (122) comprises a through hole (1222);
a dielectric layer (114) disposed between the gate (112G) and the organic layer (120); and
a light emitting unit (102) disposed on the organic layer (120), the light emitting unit (102) being electrically connected to the driving layer (118) by a bonding pad (1280, 1282);
wherein a portion of the drain (116D) is exposed by the connecting hole (1220) and a portion of an upper surface of the dielectric layer (114) is exposed by the through hole (1222), wherein the upper surface of the dielectric layer (114) is disposed far away from the substrate (100) in a top view direction (V),
wherein a ratio of an area of the through hole portion (122) overlapped with the bonding pad (1280, 1282) to an area of the bonding pad (1280, 1282) is greater than or equal to 0.3 and less than or equal to 3 in the top view direction (V) of the electronic device (10),
wherein the light emitting unit (102) comprises a conductive pad (130) electrically connected to the bonding pad (1280, 1282), the light emitting unit (102) overlaps the bonding pad (1280, 1282) in the top view direction (V), and the conductive pad (130) overlaps the bonding pad (1280, 1282) in the top view direction (V).

2. The electronic device (10) according to claim 1, wherein the ratio is greater than or equal to 0.5.

3. The electronic device (10) according to any one of claims 1 to 2, wherein the driving layer (118) comprises a signal line (134) overlapped with the through hole portion (122) in the top view direction (V) of the electronic device (10).

4. The electronic device (10) according to claim 3, wherein the organic layer (120) comprises a sidewall (SW) surrounding the through hole (1222), and an angle (θ) between the sidewall (SW) and the signal line (134) is not a right angle.

5. The electronic device (10) according to claim 4, wherein the angle (θ) is greater than or equal to 10 degree and less than or equal to 80 degree.

6. The electronic device (10) according to any one of claims 1 to 3, wherein the through hole portion (122) comprises a plurality of through holes (1222).

7. The electronic device (10) according to any one of claims 1 to 6, wherein the electronic device (10) further comprises a conductive layer (124) disposed in the through hole portion (122) overlapped with the bonding pad (1280, 1282).

8. The electronic device (10) according to claim 7, wherein the conductive layer (124) comprises a plurality of first recesses (124R).

9. The electronic device (10) according to claim 8, wherein the bonding pad (1280, 1282) is disposed between the light emitting unit (102) and the conductive layer (124), and a portion of the bonding pad (1280, 1282) is disposed in the plurality of first recesses (124R).

10. The electronic device (10) according to claim 9, wherein a top surface of the bonding pad (1280, 1282) comprises a plurality of second recesses (128R).

11. The electronic device (10) according to claim 10, wherein at least a portion of the plurality of second recesses (128R) are overlapped with at least a portion of the plurality of first recesses (124R).

## Patentansprüche

1. Elektronische Vorrichtung (10), welche umfasst:
ein Substrat (100);
eine Treiberschicht (118), die auf dem Substrat (100) angeordnet ist, worin die Treiberschicht (118) einen Dünnfilmtransistor (1060) umfasst, und der Dünnfilmtransistor (1060) einen Drain (116D), eine Quelle (116S) und ein Gatter (112G) umfasst;
eine organische Schicht (120), die auf der Treiberschicht (118) angeordnet ist, worin die organische Schicht (120) ein Verbindungsloch (1220) und einen Durchgangslochabschnitt (122) umfasst, worin der Durchgangslochabschnitt (122) ein Durchgangsloch (1222) umfasst;
eine dielektrische Schicht (114), die zwischen dem Gatter (112G) und der organischen Schicht (120) angeordnet ist; und
eine lichtemittierende Einheit (102), die auf der organischen Schicht (120) angeordnet ist, worin die lichtemittierende Einheit (102) mit der Treiberschicht (118) durch ein Verbindungskissen (1280, 1282) elektrisch verbunden ist;
worin ein Teil des Drains (116D) durch das Verbindungsloch (1220) freigelegt ist und ein Teil einer oberen Fläche der dielektrischen Schicht (114) durch das Durchgangsloch (1222) freigelegt ist, worin die obere Fläche der dielektrischen Schicht (114) in einer Draufsichtrichtung (V) weit weg von dem Substrat (100) angeordnet ist,
worin ein Verhältnis einer Fläche des Durchgangslochabschnitts (122), der mit dem Verbindungskissen (1280, 1282) überlappt, zu einer Fläche des Verbindungskissens (1280, 1282) größer als oder gleich 0,3 und weniger als oder gleich 3 in der Draufsichtsrichtung (V) der elektronischen Vorrichtung (10) ist,
worin die lichtemittierende Einheit (102) ein Kontaktkissen (130) umfasst, das mit dem Verbindungskissen (1280, 1282) elektrisch verbunden ist, die lichtemittierende Einheit (102) das Verbindungskissen (1280, 1282) in der Draufsichtsrichtung (V) überlappt und das Kontaktkissen (130) dem Verbindungskissen (1280, 1282) in der Draufsichtsrichtung (V) überlappt.

2. Elektronische Vorrichtung (10) nach Anspruch 1, worin das Verhältnis größer als oder gleich 0,5 ist.

3. Elektronisches Bauelement (10) nach einem der Ansprüche 1 bis 2, worin die Treiberschicht (118) eine Signalleitung (134) umfasst, die mit dem Durchgangslochabschnitt (122) in der Draufsichtsrichtung (V) des elektronischen Bauelements (10) überlappt.

4. Elektronische Vorrichtung (10) nach Anspruch 3, worin die organische Schicht (120) eine Seitenwand (SW) umfasst, die das Durchgangsloch (1222) umgibt, und ein Winkel (θ) zwischen der Seitenwand (SW) und der Signalleitung (134) kein rechter Winkel ist.

5. Elektronische Vorrichtung (10) nach Anspruch 4, worin der Winkel (θ) größer als oder gleich 10 Grad und kleiner als oder gleich 80 Grad ist.

6. Elektronisches Gerät (10) nach einem der Ansprüche 1 bis 3, worin der Durchgangslochabschnitt (122) mehrere Durchgangslöcher (1222) umfasst.

7. Elektronisches Bauelement (10) nach einem der Ansprüche 1 bis 6, worin das elektronische Bauelement (10) ferner eine leitende Schicht (124) umfasst, die in dem Durchgangslochabschnitt (122) angeordnet ist und sich mit dem Verbindungskissen (1280, 1282) überlappt.

8. Elektronische Vorrichtung (10) nach Anspruch 7, worin die leitende Schicht (124) mehrere erste Aussparungen (124R) umfasst.

9. Elektronische Vorrichtung (10) nach Anspruch 8, worin die Kontaktierungskissen (1280, 1282) zwischen der lichtemittierenden Einheit (102) und der leitenden Schicht (124) angeordnet ist und ein Teil des Kontaktierungskissens (1280, 1282) in den mehreren ersten Ausnehmungen (124R) angeordnet ist.

10. Elektronische Vorrichtung (10) nach Anspruch 9, worin eine obere Fläche des Verbindungskissens (1280, 1282) mehrere zweite Ausnehmungen (128R) umfasst.

11. Elektronische Vorrichtung (10) nach Anspruch 10, worin mindestens ein Teil der mehreren zweiten Vertiefungen (128R) mit mindestens einem Teil der mehreren ersten Vertiefungen (124R) überlappt.

## Revendications

1. Dispositif électronique (10) comprenant:
un substrat (100);
une couche de commande (118) disposée sur le substrat (100), dans laquelle la couche de commande (118) comprend un transistor à film mince (1060), et le transistor à film mince (1060) comprend un drain (116D), une source (116S) et une grille (112G);
une couche organique (120) disposée sur la couche de commande (118), la couche organique (120) comprenant un trou de connexion (1220) et une partie de trou traversant (122), dans laquelle la partie de trou traversant (122) comprend un trou traversant (1222);
une couche diélectrique (114) disposée entre la grille (112G) et la couche organique (120); et
une unité d'émission de lumière (102) disposée sur la couche organique (120), l'unité d'émission de lumière (102) étant connectée électriquement à la couche de commande (118) par un tampon de liaison (1280, 1282);
dans lequel une partie du drain (116D) est exposée par le trou de connexion (1220) et une partie d'une surface supérieure de la couche diélectrique (114) est exposée par le trou traversant (1222), dans lequel la surface supérieure de la couche diélectrique (114) est disposée loin du substrat (100) dans une direction de vue de dessus (V),
dans lequel un rapport d'une surface de la partie de trou traversant (122) chevauchée par le tampon de liaison (1280, 1282) à une surface du tampon de liaison (1280, 1282) est supérieur ou égal à 0,3 et inférieur ou égal à 3 dans la direction de vue de dessus (V) du dispositif électronique (10),
dans lequel l'unité d'émission de lumière (102) comprend un tampon conducteur (130) connecté électriquement au tampon de liaison (1280, 1282), l'unité d'émission de lumière (102) chevauche le tampon de liaison (1280, 1282) dans la direction de vue de dessus (V), et le tampon conducteur (130) chevauche le tampon de liaison (1280, 1282) dans la direction de vue de dessus (V).

2. Dispositif électronique (10) selon la revendication 1, dans lequel le rapport est supérieur ou égal à 0,5.

3. Dispositif électronique (10) selon l'une des revendications 1 à 2, dans lequel la couche de commande (118) comprend une ligne de signal (134) chevauchée à la partie de trou traversant (122) dans la direction de vue de dessus (V) du dispositif électronique (10).

4. Dispositif électronique (10) selon la revendication 3, dans lequel la couche organique (120) comprend une paroi latérale (SW) entourant le trou traversant (1222), et un angle (θ) entre la paroi latérale (SW) et la ligne de signal (134) n'est pas un angle droit.

5. Dispositif électronique (10) selon la revendication 4, dans lequel l'angle (θ) est supérieur ou égal à 10 degrés et inférieur ou égal à 80 degrés.

6. Dispositif électronique (10) selon l'une des revendications 1 à 3, dans lequel la partie de trou traversant (122) comprend une pluralité de trous traversants (1222).

7. Dispositif électronique (10) selon l'une quelconque des revendications 1 à 6, dans lequel le dispositif électronique (10) comprend en outre une couche conductrice (124) disposée dans la partie de trou traversant (122) chevauchant le tampon de liaison (1280, 1282).

8. Dispositif électronique (10) selon la revendication 7, dans lequel la couche conductrice (124) comprend une pluralité de premiers évidements (124R).

9. Dispositif électronique (10) selon la revendication 8, dans lequel le tampon de liaison (1280, 1282) est disposé entre l'unité d'émission de lumière (102) et la couche conductrice (124), et une partie du tampon de liaison (1280, 1282) est disposée dans la pluralité de premiers évidements (124R).

10. Dispositif électronique (10) selon la revendication 9, dans lequel une surface supérieure du tampon de liaison (1280, 1282) comprend une pluralité de seconds évidements (128R).

11. Dispositif électronique (10) selon la revendication 10, dans lequel au moins une partie de la pluralité de seconds évidements (128R) est chevauchant à au moins une partie de la pluralité de premiers évidements (124R).
